# EUROPÄISCHE PATENTANMELDUNG

(11) **EP 0 825 711 A2**
(43) Veröffentlichungstag der Anmeldung: **25.02.1998**
(21) Anmeldenummer: 97110990.5
(22) Anmeldetag: 02.07.1997
(51) Int. Cl.: H03G 3/30

(54) **Verfahren zur automatischen Anpassung eines Empfängers an verschiedene Signalstärken und Empfänger zur Durchführung des Verfahrens**

(30) Priorität: 16.08.1996 DE 19632902
(71) Anmelder: ROBERT BOSCH GMBH, 70442 Stuttgart (DE)
(72) Erfinder: Bolliger, Urs, 4553 Subingen (CH)

(57) **Zusammenfassung**

Es wird ein Verfahren zur automatischen Anpassung eines Empfängers an verschiedene Signalstärken bei der digitalen Funkübertragung vorgeschlagen, die dazu dient, ein verzerrungsfreies Signal zu erzeugen. Dabei werden die Vorteile einer automatischen Verstärkungsregelung genutzt.

## Beschreibung

### Stand der Technik

Die Erfindung geht aus von einer automatischen Anpassung eines Empfängers an verschiedene Signalstärken sowie eines Empfängers bei einer digitalen Funkübertragung nach der Gattung des unabhängigen Patentanspruchs.

Ein Empfänger für Funksignale muß Eingangssignale im Bereich von unter 1 µV bis ca. 1 V verarbeiten können. Übliche Empfänger haben darum eine Einrichtung, die den Dynamikbereich reduziert. Dies kann eine Begrenzung des Signals oder eine automatische Verstärkungsregelung (Automatic Gain Control, im folgenden AGC genannt) sein.

Je nach Modulationsart ist eine Begrenzung zugelassen oder nicht. Bei linearen, digitalen Modulationsarten ist sie nur für größere Eingangspegel und auch dort nur unter gewissen Bedingungen zugelassen. Es wird daher meist mit einer AGC gearbeitet. Eine AGC hat den Vorteil, daß das empfangene Signal nicht verzerrt wird. Nachteilig ist, daß die Einstellung der Verstärkung immer eine gewisse Zeit, gegeben durch die Zeitkonstante, benötigt. Zwar kann die Zeitkonstante einer AGC meist frei gewählt werden, eine zu kleine Zeitkonstante kann jedoch die Modulation beeinflussen und das Empfangssignal verzerren.

In einem digitalen Funksystem mit TDMA-Signalisierung (Time Division Multiple Access) besteht eine Funkzelle im Normalfall aus einer Basisstation und mehreren Mobilstationen. Die Mobilstationen empfangen dauernd ein Funksignal von der Basisstation, auch wenn kein Gespräch stattfindet. Die AGC des mobilen Gerätes ist damit problemlos, die Zeitkonstante kann relativ groß gewählt werden. Anders verhält es sich bei der Basisstation. Die Mobilstationen senden nicht dauern, sondern nur in einem ihnen zugewiesenen Zeitschlitz. Ein solches Sendepaket wird Burst genannt. Beginnt ein Mobilgerät zu senden, muß die Basisstation sofort empfangsbereit sein. Die Größe des empfangenen Signals kann nicht vorausgesagt werden. Damit die AGC genügend schnell nachgeregelt werden kann, muß die Zeitkonstante derart klein sein, daß eine Verzerrung des Signal nicht zu vermeiden ist. Aus diesen Gründen wird in Basisstationen nach dem Stand der Technik auf eine AGC verzichtet. Statt dessen wird ein Empfänger mit hoher Dynamik eingesetzt, der nur starke Signale begrenzt. Da diese hohe Dynamik von der Antenne bis zur Demodulation erhalten bleiben muß, sind die Anforderungen an die Bauteile hoch. Die Herstellkosten eines solchen Empfängers sind daher höher, als die eines Empfängers mit einer AGC. Zudem entstehen bei hohen Eingangssignalen in Folge der Begrenzung Modulationsverzerrungen.

### Vorteile der Erfindung

Die erfindungsgemäße Anpassung mit den kennzeichnenden Merkmalen des unabhängigen Patentanspruchs hat demgegenüber den Vorteil, daß im Analogteil des Empfängers eine AGC eingesetzt wird, dessen Verzerrungen in einem Digitalteil durch einen speziellen Signalprozessor rückgängig gemacht wird. Der Aufwand für eine solche Lösung ist üblicherweise gering, da die zusätzliche Funktion im digitalen Signalprozessor durch eine einfache Softwareroutine erledigt wird.

Durch die in den Unteransprüchen aufgeführten Maßnahmen sind vorteilhafte Weiterbildungen und Verbesserungen der im unabhängigen Patentanspruchs angegebenen Anpassung möglich.

Besonders vorteilhaft ist es, daß die Korrekturen für die Entzerrung des Signals im Signalprozessor über den Vergleich mit einer Tabelle erfolgen.

Eine einfache Lösung stellt die Korrektur der Verzerrung des Signals über einen Vergleich mit einem Funktionsverlauf eines Signals, der im Prozessor gespeichert ist, dar.

Eine vorteilhafter Aufbau eines Empfängers weist eine Analog- und einen Digitalteil auf, wobei die Signalverzerrung des analogen Signals nach der Digitalisierung mit einem Signalprozessor aufgehoben wird.

Eine weitere vorteilhafte Ausführungsform verwendet eine automatische Verstärkungsregelung mit umschaltbaren Regelzuständen, so daß der Empfänger sehr schnell in einen optimalen Regelzustand gebracht wird.

Dabei wird beim Hochfahren des Senders im Mobilgerät die AGC in den Regelzustand R1 mit einer kleinen Zeitkonstante gesteuert.. So kann sie den Verlauf der Empfangsfeldstärken folgen und die optimale Einstellung finden.

Die Regelzustände sind vorteilhafterweise von festen Zeitfenstern vorgegeben.
Es ist auch möglich, die Regelzustände über ein Steuersignal zu schalten, das z.B. vom Regelsignal der automatischen Verstärkungsregelung abgegriffen wird.

Vorteilhafterweise wird die einstellbare Zeitkonstante so geschaltet, daß die Verstärkung während eines digitalen Sendepakets (Burst) konstant gehalten wird.

### Zeichnung

Ausführungsbeispiele der Erfindung sind in den Zeichnungen dargestellt und in der nachfolgenden Beschreibung näher erläutert. Es zeigen Figur 1 das Blockdiagramm für die schnelle AGC mit Digitalteil, Figur 2 das Blockdiagramm für die AGC mit umschaltbarer Zeitkonstante und Figur 3 die zeitliche Abfolge für die AGC mit umschaltbarer Zeitkonstanten.

### Beschreibung der Ausführungsbeispiele

Moderne Empfänger führen die Operation Demodulation-Detektion und Kanalentzerrung oft mittels digitaler Signalverarbeitung im sog. Basisband durch. Dabei wird das Empfangssignal zuerst mit Hilfe eines orthogonalen Trägerpaares (zwei um 90° phasenverschobene Sinusschwingungen) und eines Paars von Mischern direkt, oder ab einer Zwischenfrequenzlage, auf die Frequenzlage f = 0 gemischt. Die momentane Phase und Amplitude des derart umgesetzten Empfangssignals kann dann aus den beiden Signalkomponenten im Basisband dem in Phasen- und dem Quadratursignal (I- und Q-Signal) bestimmt werden.

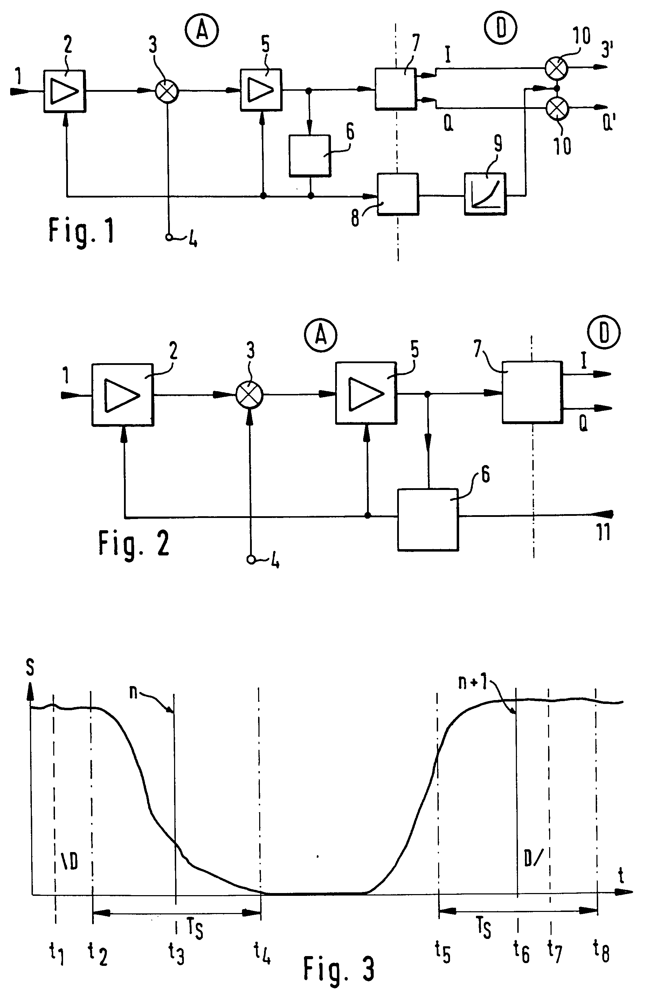

Nach Figur 1 wird das RF-Antennensignal 1 vom Hochfrequenzverstärker 2 verstärkt. Im Mischer 3 wird das Signal mit Hilfe des Lokaloszillators 4 heruntergemischt und an den Zwischenverstärker 5 weitergegeben. Beide Verstärker sind regelbar. Es ist jedoch auch möglich, nur einen der beiden Verstärker regelbar zu gestalten. Der nachfolgende AGC-Generator 6 erzeugt die Regelspannung. Damit ist die Regelschleife geschlossen. Das Zwischenfrequenzsignal, das nun durch die Regelung eine konstante Amplitude aufweist (soweit der Regelumfang des geregelten Verstärkers nicht überschritten wird) wird im Block AD-Wandler 7 ins Basisband umgesetzt und digitalisiert. Die Reihenfolge dieses Vorgehens kann auch umgekehrt sein, es kann also zuerst die AD-Wandlung und dann die Umsetzung ins Basisband erfolgen. Die vom AGC-Generator erzeugte Regelspannung wird im Digitalteil des Empfängers ebenfalls digitalisiert 8 und mit einer Korrekturtabelle oder Funktion 9 mit dem Basisbandsignal in den Multiplikatoren 10 multipliziert. Auf diese Weise wird die ursprüngliche Amplitude des Signals wieder hergestellt und evtl. aufgetretene Modulationsverzerrungen aufgehoben. Die Korrekturtabelle 9 ist im allgemeinen nötig, weil der Zusammenhang zwischen Verstärkung und Regelspannung normalerweise nicht linear ist.

Ein Empfänger muß für die Ausführung dieses Verfahrens zu einem analogen Empfangstteil mit automatischer Verstärkungsregelung noch einen Digitalteil mit einem Signalprozessor aufweisen.

In Figur 2 wird eine weitere Ausführungsform der automatischen Anpassung des Empfängers bei stark schwankenden Signalen vorgestellt. Das eingehende Hochfrequenzsignal 1 wird wie bereits beschrieben, verstärkt 2, auf das Basisband heruntergemischt und mit dem AGC-Generator geregelt. Der AGC-Generator 6 hat dabei eine umschaltbare Zeitkonstante. Die Umschaltung wird durch ein Steuersignal aus dem Signalteil 11 gesteuert. Zur Steuerung werden zunächst zwei Zeitfenster konstanter Länge im Empfänger festgelegt. Während des Zeitfensters 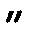 Ramping" ist die AGC im Zustand 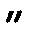 schnell", während des Zeitfensters 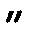 Daten" im Zustand 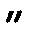 langsam". Durch die zeitliche Synchronisation mit der Basisstation sind den Mobilstationen diese Zeitfenster ebenfalls bekannt. Sie werden daher mit der Aussendung des ersten Bursts immer im Zeitfenster 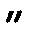 Ramping" beginnen. Die AGC hat nun bis zum Beginn des Fenster 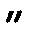 Daten" Zeit, die richtige Verstärkung einzustellen.

Die zeitliche Synchronisation zwischen Basis und Mobilstationen ist mit Toleranzen behaftet. Im Extremfall muß mit Fehlern gerechnet werden: die Umschaltung 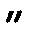 langsam" auf 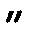 schnell" ist kein Problem, siehe Fig. 3. Hier ist die Signalamplitude über der Zeit aufgetragen. Zur Zeit t₁ sind die Daten übertragen und es folgen die Kennzeichnung des Endes der Übertragung. Zur Zeit t₂ beginnt der Empfänger mit der Umschaltung des Zustandes von 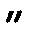 langsam" auf 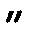 schnell". t₃ zeigt das Ende der Burst n an. Der Empfänger hat während der Zeit T_{S} Zeit den Regelvorgang vorzunehmen. Während des nächsten Intervalls T_{S} wird ein Burst n+1 gesendet. Die Daten des Burst n+1 setzen zum Zeitpunkt t₇ ein.
Der Zeitpunkt der richtigen Umschaltung von 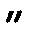 schnell" auf 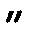 langsam" ist sehr von Bedeutung. Im Idealfall liegt dieser Punkt am Ende des Anstiegs der Leistung, z.B. bei t₆, noch vor den ersten gültigen Daten. Bei zu früher Umschaltung z.B. bei t₅ ist die volle Leistung noch nicht erreicht, der AGC-Wert wird falsch gesetzt. Erfolgt die Umschaltung zu spät, z. B. bei t₈, wird zwar die AGC richtig gesetzt, die ersten Datenbits jedoch verzerrt.

In einer verbesserten Version wird daher das HF-Signal für die Generierung des Umschaltkriteriums mit einbezogen. Der genaue Zeitpunkt des Leistungsanstiegs wird durch Detektion der Amplitude, durch eine Feldstärkemessung festgestellt. Da die vom AGC-Generator erzeugte Regelspannung ein Maß für die Amplitude ist, braucht es dazu keine weitere Schaltungsteile. Durch Mehrwegeausbreitung kann allerdings das HF-Signal schwanken und so dem Meßsystem einen falschen Zeitpunkt des Leistungsanstiegs vorspielen. Die Verknüpfung Steuersignal-Amplitudendetektion muß daher eine gewisse Intelligenz beinhalten. Je nach Anwendung sieht die optimale Lösung unterschiedlich aus.

Der Empfänger muß für das Verfahren eine automatische Verstärkungsregelung mit einem Steuereingang aufweisen.

## Patentansprüche

1. Verfahren zur automatischen Anpassung eines Empfängers an unterschiedliche Signalstärken bei der digitalen Funkübertragung, vorzugsweise in einem Betriebsfunknetz, mit Hilfe einer automatischen Verstärkungsregelung, dadurch gekennzeichnet, daß das durch die automatische Verstärkungsregelung im Empfänger verzerrte Signal einer Bearbeitung mit einem digitalen Signalprozessor unterzogen wird.

2. Verfahren zur automatischen Anpassung eines Empfängers an verschiedene Signalstärken nach Anspruch 1, dadurch gekennzeichnet, daß die Entzerrung des Signals im digitalen Signalprozessor über eine Tabellenvergleich erfolgt.

3. Verfahren zur automatischen Anpassung eines Empfängers an verschiedene Signalstärken nach Anspruch 1 oder 2, dadurch gekennzeichnet, daß die Entzerrung des Signals im digitalen Signalprozessor über Vergleich mit einem Funktionsverlauf erfolgt.

4. Empfänger nach Anspruch 1 bis 3, dadurch gekennzeichnet, daß im Empfänger ein Analogteil mit automatischer Verstärkungsregelung und ein Digitalteil mit einem Signalprozessor vorhanden ist.

5. Verfahren zur automatischen Anpassung eines Empfängers an verschiedene Signalstärken bei der digitalen Funkübertragung, vorzugsweise in einem Betriebsfunknetz, mit Hilfe einer automatischen Verstärkungsregelung, dadurch gekennzeichnet, daß die automatische Verstärkungsregelung zwischen zwei Regelungszuständen R1 und R2 umgeschaltet wird.

6. Verfahren zur automatischen Anpassung eines Empfängers nach Anspruch 5, dadurch gekennzeichnet, daß die Zeitkonstante der automatischen Verstärkungsregelung im Regelzustand R1 klein und im Regelzustand R2 groß ist.

7. Verfahren zur automatischen Anpassung eines Empfängers an verschiedene Signalstärken nach Anspruch 5 oder 6, dadurch gekennzeichnet, die Regelzustände nach festen Zeitfenster im Empfänger umgeschaltet werden.

8. Verfahren zur automatischen Anpassung eines Empfängers an verschiedene Signalstärken nach Anspruch 5 bis 7, dadurch gekennzeichnet, daß eine Datenübertragung im Zeitfenster des Regelzustands R1 beginnt.

9. Verfahren zur automatischen Anpassung eines Empfängers an verschiedene Signalstärken nach Anspruch 5 bis 8, dadurch gekennzeichnet, daß die Umschaltung des Regelzustands R2 nach R1 des Empfängers vom Leistungsanstieg des Sendesignals gesteuert wird.

10. Verfahren zur automatischen Anpassung eines Empfängers an verschiedene Signalstärken nach Anspruch 5 bis 9, dadurch gekennzeichnet, daß das Steuersignal von der Regelspannung der automatischen Verstärkungsregelung abgeleitet wird.

11. Verfahren zur automatischen Anpassung eines Empfängers an verschiedene Signalstärken nach Anspruch 5 bis 10, dadurch gekennzeichnet, daß der Regelzustand R2 des Empfängers während der Sendung konstant gehalten wird.

12. Empfänger zur Durchführung des Verfahrens nach Anspruch 5 bis 11, dadurch gekennzeichnet, daß der Empfänger eine automatische Verstärkungsregelung mit einem Steuereingang für Steuerung der Regelzustände aufweist.
